# DEMANDE DE BREVET EUROPEEN

(11) **EP 4 543 182 A1**
(43) Date de publication de la demande: **23.04.2025**
(21) Numéro de dépôt: 24207415.1
(22) Date de dépôt: 18.10.2024
(51) Int. Cl.: H10N 10/01, H10N 10/13, B33Y 80/00, B22F 10/28, B33Y 10/00

(54) **PROCÉDÉ DE FABRICATION D'UN DISPOSITIF THERMOÉLECTRIQUE MUNI D'UN DISSIPATEUR THERMIQUE**

(30) Priorité: 20.10.2023 FR 2311393
(71) Demandeur: Commissariat à l'Energie Atomique et aux Energies Alternatives, 75015 Paris (FR)
(72) Inventeur: SAVELLI, Guillaume, 38054 CEDEX 9 GRENOBLE (FR); BAUDRY, Maxime, 38054 CEDEX 9 GRENOBLE (FR); ROUX, Guilhem, 38054 CEDEX 9 GRENOBLE (FR)
(74) Mandataire: Gevers & Orès

(57) **Abrégé**

L'invention concerne un procédé de fabrication d'un dispositif thermoélectrique muni d'un dissipateur thermique comportant les étapes suivantes :
A) réaliser (100) une première partie dudit dispositif thermoélectrique, ladite première partie étant munie d'un dissipateur thermique, étape A) au cours de laquelle on dépose, par fabrication additive, une première série de plots réalisés en un matériau semi-conducteur avec un type de dopage donné ;
B) réaliser (200) une deuxième partie du dispositif thermoélectrique, étape B) au cours de laquelle on dépose, par fabrication additive, une deuxième série de plots réalisés en un matériau semi-conducteur avec un autre type de dopage ;
C) assembler (300) la deuxième partie du dispositif à la première partie.

## Description

### Domaine technique de l'invention

L'invention se rapporte au domaine de fabrication de dispositifs thermoélectriques munis d'un dissipateur thermique.

### Arrière-plan technique

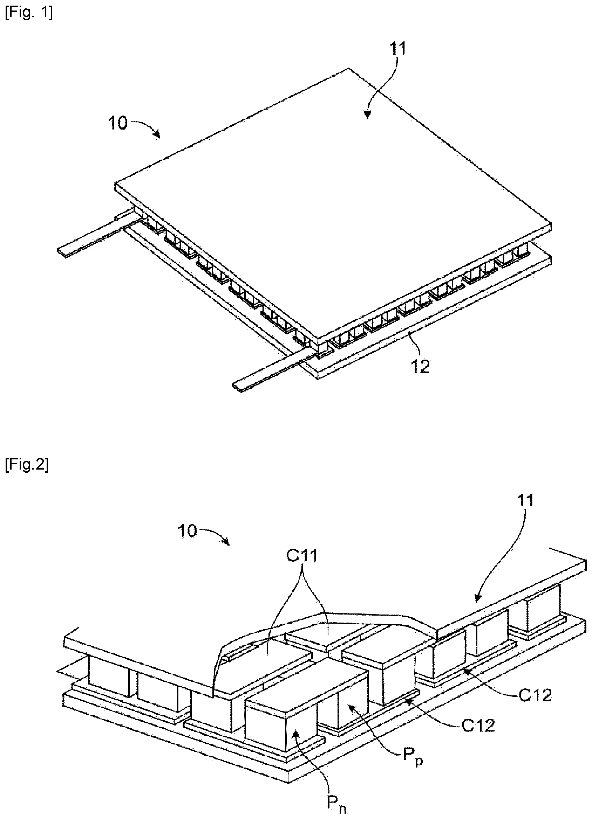

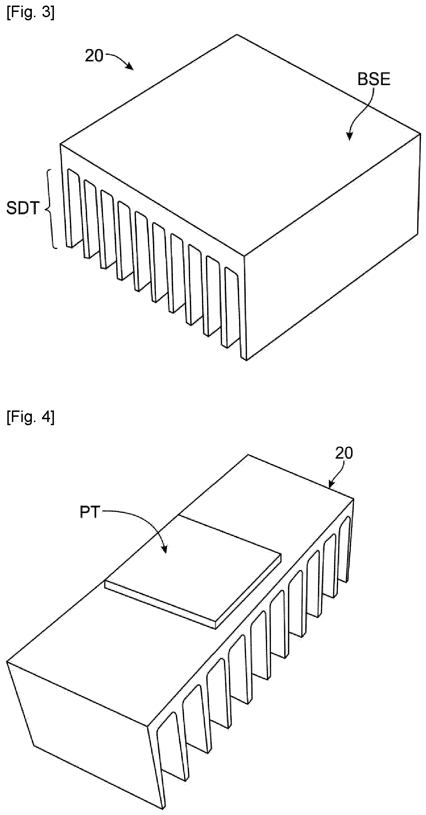

La figure 1 montre un dispositif thermoélectrique sans dissipateur thermique. La figure 2 représente le dispositif thermoélectrique de la figure 1 selon une vue agrandie et partiellement éclatée. La figure 3 montre un dissipateur thermique destiné à être installé contre une face du dispositif thermoélectrique.

Un tel dispositif thermoélectrique 10 comprend typiquement deux substrats 11, 12 réalisés en un matériau non conducteur de l'électricité, souvent en céramique, et sur lesquels sont montés des connexions métalliques C11, C12 à partir desquelles s'étendent des plots Pₚ, Pₙ réalisés en matériaux semi-conducteurs de type p et n respectivement. Ces plots Pₚ, Pₙ sont connectés en série électriquement. Sur le plan thermique, un tel dispositif thermoélectrique 10 fonctionne en revanche en parallèle.

Les performances électriques d'un dispositif thermoélectrique en mode générateur sont données par :
- une résistance électrique interne Rᵢₙₜ = N × ρₙₚ × L / A + Rₘₑₜ + R_{c} avec :
   N, le nombre de jonctions np, L, la longueur d'un plot, A, la section d'un plot, et ρₙₚ, la résistivité de la jonction np, ces différents paramètres permettant de définir la résistance totale des plots,
   Rₘₑₜ, la résistance totale des connexions métalliques, et
   R_{c}, la résistance totale des contacts ;
- une tension V générée (mode générateur) par le dispositif thermoélectrique sous l'effet d'une différence de température ΔT aux extrémités du dispositif thermoélectrique : V = N × Sₙₚ × ΔT avec Sₙₚ = Sₚ - Sₙ, les coefficients Seebeck des matériaux des plots p et n, respectivement.

La puissance électrique utile Pᵤ s'écrit alors par définition : Pᵤ = V²/ 4Rᵢₙₜ.

Pour disposer d'une puissance élevée, il faut donc avoir notamment une tension élevée, et donc avoir un ΔT élevé, d'où l'intérêt du dissipateur thermique 20, monté contre le substrat 12 par exemple.

Classiquement, la fabrication du dispositif thermoélectrique 10 et celle du dissipateur thermique 20 s'effectuent séparément et un assemblage final est alors effectué entre les deux.

En ce qui concerne le dispositif thermoélectrique, il convient de fournir un substrat en matériau isolant électrique et déposer les différentes connexions métalliques. Ceci s'effectue pour chaque substrat 11, 12. Les plots en matériaux semi-conducteurs sont typiquement réalisés par frittage. A cet effet, on fabrique par frittage des plaques du matériau semi-conducteur dans lequel on souhaite réaliser les plots semi-conducteurs puis, on effectue une découpe des plots aux dimensions souhaitées. On comprend que cette opération va s'effectuer pour les plots dopés p d'une part et les plots dopés n d'autre part. Une fois ces plots obtenus, il convient de les disposer au bon endroit sur les connexions métalliques C11, C12 et d'assurer leur tenue mécanique sur ces plots, par exemple par brasure.

Le dissipateur thermique 20 est quant à lui formé d'une base BSE à partir de laquelle s'étend une structure de dissipation thermique SDT. Le dissipateur thermique 20 est typiquement réalisé en un matériau bon conducteur thermique. Il peut être fabriqué de différentes façons, par exemple par usinage d'un bloc plein du matériau dans lequel il est réalisé, pour obtenir une structure de dissipation thermique SDT se présentant sous la forme d'ailettes (figure 3) ou autres.

L'assemblage entre le dispositif thermoélectrique 10 proprement dit et le dissipateur thermique 20 peut s'effectuer au moyen d'une pâte capable de durcir sous l'effet de chaleur (pâte thermique) et/ou par un assemblage mécanique. On a par exemple représenté sur la figure 4 comment s'effectue, avec une pâte thermique PT, l'assemblage entre le dispositif thermoélectrique 10 et le dissipateur thermique 20.

Les étapes de fabrication sont multiples voire nombreuses. Cela a donc une conséquence sur le temps et les coûts de fabrication. Par ailleurs, la technique employée pour fabriquer les plots semi-conducteurs ne permet en pratique que de réaliser des formes parallélépipédiques. Cela limite le champ du possible pour le dimensionnement du dispositif thermoélectrique, notamment au regard de l'application visée et des contraintes techniques que cette application impose.

Un objectif de l'invention est de proposer un procédé de fabrication d'un dispositif thermoélectrique muni d'un dissipateur thermique ne présentant pas l'un au moins des inconvénients précités.

### Résumé de l'invention

Pour résoudre l'objectif précité, l'invention propose un procédé de fabrication d'un dispositif thermoélectrique muni d'un dissipateur thermique comportant les étapes suivantes :
A) réaliser une première partie dudit dispositif thermoélectrique, ladite première partie étant munie d'un dissipateur thermique, selon les sous-étapes suivantes :
   - fournir un dissipateur thermique muni d'une base, ladite base étant plane et réalisée en un matériau isolant électrique,
   - déposer une première série de connexions métalliques sur la base du dissipateur thermique selon un motif prédéfini, et
   - déposer, par fabrication additive, une première série de plots réalisés en un matériau semi-conducteur avec un type de dopage donné de sorte qu'un plot semi-conducteur est déposé sur l'une et l'une seule des deux extrémités de chaque connexion métallique de la première série de connexions métalliques,
B) réaliser une deuxième partie du dispositif thermoélectrique selon les sous-étapes suivantes :
   - fournir une plaque réalisée en un matériau isolant électrique,
   - déposer une deuxième série de connexions métalliques sur ladite plaque, selon un motif identique à celui de la première série de connexions métalliques, et
   - déposer, par fabrication additive, une deuxième série de plots réalisés en un matériau semi-conducteur avec un autre type de dopage de sorte qu'un plot semi-conducteur est déposé sur l'une et l'une seule des deux extrémités d'une connexion métallique de la deuxième série de connexions métalliques,
C) assembler la deuxième partie du dispositif à la première partie du dispositif selon les sous-étapes suivantes :
   - agencer une extrémité libre d'un plot semi-conducteur de la première partie du dispositif contre une extrémité libre de chaque connexion métallique de la deuxième partie du dispositif, et dans le même temps, agencer une extrémité libre d'un plot semi-conducteur de la deuxième partie du dispositif contre une extrémité libre de chaque connexion métallique de la première partie du dispositif, et
   - réaliser un pressage à chaud.

Le procédé selon l'invention pourra comprendre l'une au moins des étapes additionnelles suivantes, prises seules ou en combinaison :
- le dissipateur thermique fourni à l'étape A) est réalisé, dans son ensemble, en un matériau isolant électrique, par exemple en céramique ;
- la plaque fournie à l'étape B) est réalisée en un matériau identique à celui du dissipateur thermique fourni à l'étape A) ;
- le dissipateur thermique fourni à l'étape A) comprend une structure de dissipation thermique s'étendant à partir de sa base, ladite structure de dissipation thermique étant réalisée en un matériau choisi parmi l'acier, par exemple de l'acier 316L, de l'Aluminium (AI), du Titane (Ti), un alliage de Cuivre Zirconium (CuZr) ou du graphite ;
- la base du dissipateur thermique est réalisée en un matériau choisi parmi un mica, un polymère ou une céramique, par exemple le Marcor^{®} ;
- la plaque fournie à l'étape B) est configurée pour former un autre dissipateur thermique, par exemple par la présence de canaux au sein de ladite plaque ;
- le dissipateur thermique fourni à l'étape A) est choisi parmi un dissipateur thermique à ailettes, à plots, par exemple formés de cylindres pleins, ou à canaux ;
- au cours de l'étape A), on dépose au moins une série de plots additionnels réalisés en un matériau semi-conducteur avec le même type de dopage que les plots semi-conducteurs de la première série de plots de sorte qu'un plot additionnel semi-conducteur est déposé au niveau de l'extrémité de chaque connexion métallique de la première série de connexions métalliques, parallèlement au plot semi-conducteur déjà présent de la première série de plots ; et au cours de l'étape B), on dépose au moins une autre série de plots additionnels réalisés en un matériau semi-conducteur avec le même type de dopage que les plots de la deuxième série de plots de sorte qu'un plot additionnel semi-conducteur est déposé au niveau de l'extrémité de chaque connexion métallique de la deuxième série de connexions métalliques, parallèlement au plot semi-conducteur déjà présent de la deuxième série de plots ;
- le matériau formant les plots semi-conducteurs est choisi parmi le Silicium (Si), le Silicium Germanium (SiGe), le Tellurure de Bismuth (Bi2Te3), ou dans la famille des Skuttérudites ;
- ladite technique de fabrication additive est choisie parmi : la fusion laser sur lit de poudre, par exemple la fusion sélective par laser ou le frittage sélectif par laser, ou le dépôt d'énergie direct.

### Brève description des figures

D'autres objets et caractéristiques de l'invention apparaîtront plus clairement dans la description qui suit, faite en référence aux figures annexées, dans lesquelles :
La [Fig. 5] représente de manière schématique les principales étapes de fabrication du procédé selon l'invention ;
Les [Fig. 6a], [Fig. 6b] et [Fig. 6c] représentent, dans le cadre d'un exemple de réalisation conforme à l'invention, les différentes sous-étapes de la première étape principale du procédé de fabrication schématisé sur la figure 5 ;
Les [Fig. 7a], [Fig. 7b] et [Fig. 7c] représentent, dans le cadre de ce même exemple de réalisation, les différentes sous-étapes de la deuxième étape principale du procédé de fabrication schématisé sur la figure 5 ;
La [Fig. 8] représente, dans le cadre de ce même exemple de réalisation, le dispositif thermoélectrique obtenu après la mise en oeuvre de la troisième et dernière étape principale du procédé de fabrication schématisé sur la figure 5;
La [Fig. 9] représente différentes formes de plots semi-conducteurs susceptibles d'être obtenus avec la technique de fabrication additive employée dans le cadre de l'invention ;
La [Fig. 10] représente un autre type de dispositif thermoélectrique pouvant être obtenu avec le procédé de fabrication conforme à l'invention ;
La [Fig. 11] représente encore un autre type de dispositif thermoélectrique pouvant être obtenu avec le procédé de fabrication conforme à l'invention ;
La [Fig. 12] représente un type de dissipateur thermique susceptible d'être employé ;
La [Fig. 13] représente un autre type de dissipateur thermique susceptible d'être employé.

### Description détaillée de l'invention

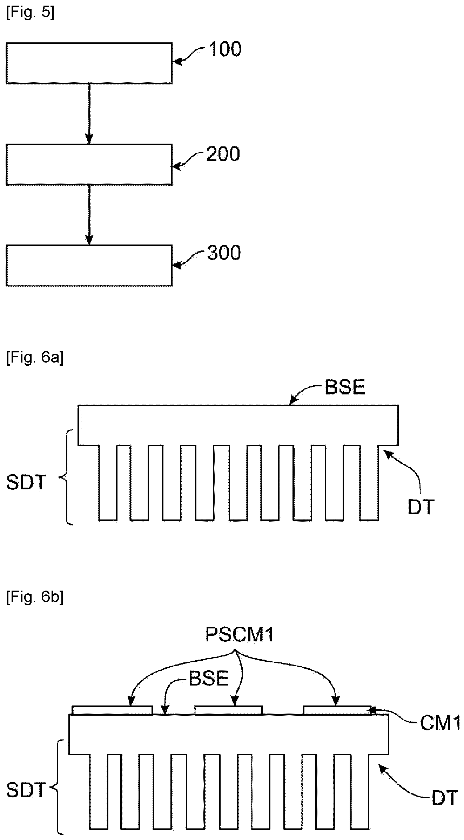

Comme cela est représenté de manière schématique sur la figure 5, l'invention concerne un procédé de fabrication d'un dispositif thermoélectrique DTE muni d'un dissipateur thermique DT comportant les étapes suivantes :
A) réaliser 100 une première partie PP du dispositif thermoélectrique DTE, ladite première partie étant munie d'un dissipateur thermique;
B) réaliser 200 une deuxième partie DP du dispositif thermoélectrique DTE ; et
C) assembler 300 la deuxième partie DP du dispositif DTE à la première partie PP du dispositif DTE.

On a représenté, en s'appuyant sur un cas plus concret, la fabrication d'un dispositif thermoélectrique DTE pour chacune des étapes principales de fabrication A), B) et C).

L'étape A) est réalisée selon les sous-étapes suivantes.

On fournit tout d'abord un dissipateur thermique DT muni d'une base BSE, ladite base BSE étant plane et réalisée en un matériau isolant électrique.

On aboutit alors à la pièce représentée sur la figure 6a.

On dépose ensuite une première série de connexions électriques métalliques PSCM1 sur la base BSE du dissipateur thermique DT selon un motif prédéfini. Ceci peut s'effectuer, de manière non limitative, par dépôt chimique en phase vapeur (plus connu sous l'acronyme CVD pour « Chemical Vapor Déposition » selon la terminologie anglo-saxonne) ou dépôt physique en phase vapeur (plus connu sous l'acronyme PVD pour « Physical Vapor Déposition » selon la terminologie anglo-saxonne).

On aboutit alors à la pièce représentée sur la figure 6b.

On note donc que la base BSE du dissipateur thermique DT sert de substrat pour le dépôt des connexions métalliques. Cela simplifie la fabrication et fait donc gagner du temps. Par ailleurs, cela permet incidemment de réduire l'épaisseur du dispositif à cet endroit et de fait permet de réduire la résistance thermique globale.

Puis, on dépose une première série de plots PSPLT1 réalisés en un matériau semi-conducteur avec un type de dopage donné (dopage n par exemple) de sorte qu'un plot PLT1 semi-conducteur est déposé sur l'une et l'une seule des deux extrémités de chaque connexion métallique CM1 de la première série de connexions métalliques PSCM1.

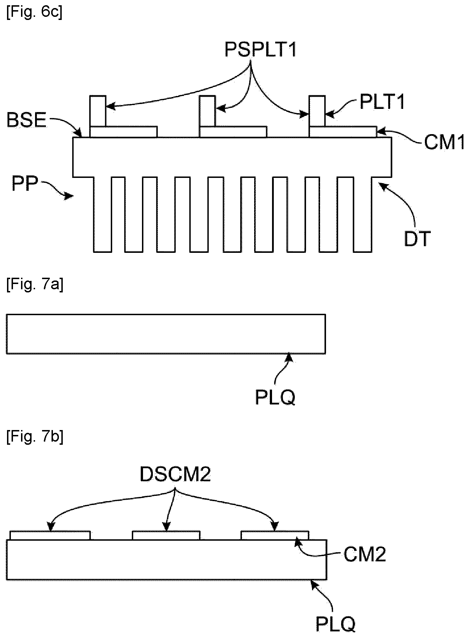

On aboutit alors à la pièce représentée sur la figure 6c, constituant la première partie PP du dispositif thermoélectrique DTE.

Il convient de préciser que dans l'invention, le dépôt des plots semi-conducteurs s'effectue par fabrication additive.

Il existe plusieurs techniques de fabrication additive susceptibles de convenir dans le cadre de l'invention.

Ainsi, on peut employer une technique dite de fusion laser sur lit de poudre. Dans ce cas, la poudre est déposée sous forme d'un lit de poudre puis on densifie la poudre avec un faisceau laser. Il peut s'agir de la fusion sélective par laser (plus connu sous l'acronyme SLM pour « Sélective Laser Melting ») ou du frittage sélectif par laser (plus connu sous l'acronyme SLS pour « Sélective Laser Sintering » selon la terminologie anglo-saxonne).

On peut aussi choisir une technique de dépôt d'énergie direct (plus connu sous l'acronyme DED pour « Direct Energy Déposition » selon la terminologie anglo-saxonne). Dans ce cas, on dépose de la poudre et celle-ci est densifiée directement par un faisceau laser ou un faisceau d'électrons.

L'étape B) est réalisée selon les sous-étapes suivantes.

On fournit une plaque PLQ réalisée en un matériau isolant électrique, laquelle est représentée sur la figure 7a.

On dépose ensuite une deuxième série de connexions métalliques DSCM2 sur la plaque PLQ. Ceci s'effectue selon un motif identique à celui de la première série de connexions métalliques PSCM1.

On aboutit à la pièce représentée sur la figure 7b.

Puis, on dépose une deuxième série de plots DSPLT2 réalisés en un matériau semi-conducteur avec un autre type de dopage (par exemple de type p) de sorte qu'un plot PLT2 semi-conducteur est déposé sur l'une et l'une seule des deux extrémités d'une connexion métallique CM2 de la deuxième série de connexions métalliques DSCM2.

Là également, le dépôt s'effectue par une technique de fabrication additive, telle que l'une de celles listées précédemment. Avantageusement, on choisit ici la même technique de fabrication additive que celle qui est employée lors de l'étape A).

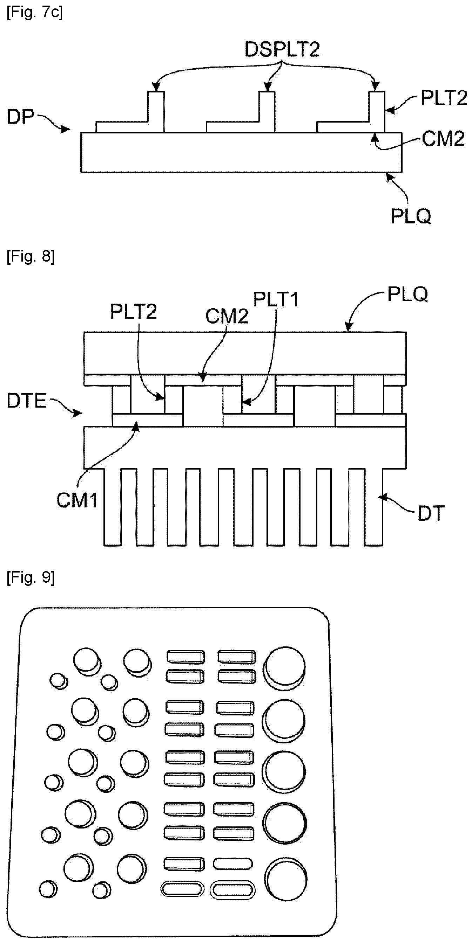

On aboutit à la pièce représentée sur la figure 7c, qui forme donc la deuxième partie DP du dispositif thermoélectrique DTE.

Enfin, l'étape C) pour assembler la deuxième partie DP à la première partie PP du dispositif thermoélectrique DTE s'effectue selon les sous-étapes suivantes.

Tout d'abord, on agence une extrémité libre d'un plot PLT1 semi-conducteur de la première partie PP du dispositif thermoélectrique DTE contre une extrémité libre de chaque connexion métallique CM2 de la deuxième partie DP du dispositif thermoélectrique DTE. Dans le même temps, on agence une extrémité libre d'un plot PLT2 semi-conducteur de la deuxième partie DP du dispositif thermoélectrique DTE contre une extrémité libre de chaque connexion métallique CM1 de la première partie PP du dispositif thermoélectrique DTE.

En pratique, cela nécessite par exemple de retourner la deuxième partie DP du dispositif thermoélectrique DTE contre la première partie PP dudit dispositif. Bien entendu, en variante, on peut faire l'inverse, cela revient au même.

Puis, on effectue une étape de pressage à chaud. Ceci permet d'assurer le maintien des deux parties PP, DP l'une contre l'autre.

Le dispositif thermoélectrique DTE muni d'un dissipateur thermique DT qui est alors finalement obtenu est représenté sur la figure 8.

Le dissipateur thermique DT fourni à l'étape A) peut être est réalisé, dans son ensemble, en un matériau isolant électrique, par ailleurs avantageusement bon conducteur thermique. Cela permet d'éviter les risques de courts-circuits entre les connexions métalliques CM1, tout en assurant un comportement thermique adapté.

On peut par exemple choisir un matériau céramique dans ce but. Dans ce cas, on comprend qu'il n'est pas nécessaire de rapporter une pâte thermique ou autre pour assembler, comme dans l'art antérieur, le dissipateur thermique à un module thermoélectrique. Le contact thermique est donc amélioré du fait d'une baisse de la résistance de contact à ce niveau.

La plaque PLQ fournie à l'étape B) peut alors être réalisée en un matériau identique à celui du dissipateur thermique DT fourni à l'étape A).

En variante, le dissipateur thermique DT fourni à l'étape A) comprend une structure de dissipation thermique SDT s'étendant à partir de sa base BSE, ladite structure de dissipation thermique étant réalisée en un matériau choisi parmi l'acier, par exemple de l'acier 316L, de l'Aluminium (AI), du Titane (Ti), un alliage de Cuivre Zirconium (CuZr) ou du graphite. Dans ce cas, la base BSE du dissipateur thermique DT se présente sous la forme d'une couche de surface réalisée en un matériau choisi parmi un mica, un polymère ou une céramique, per exemple le Marcor^{®}. L'objectif est d'assurer à la fois une bonne dissipation thermique tout en évitant les risques de court-circuit entre les différentes connexions métalliques CM1.

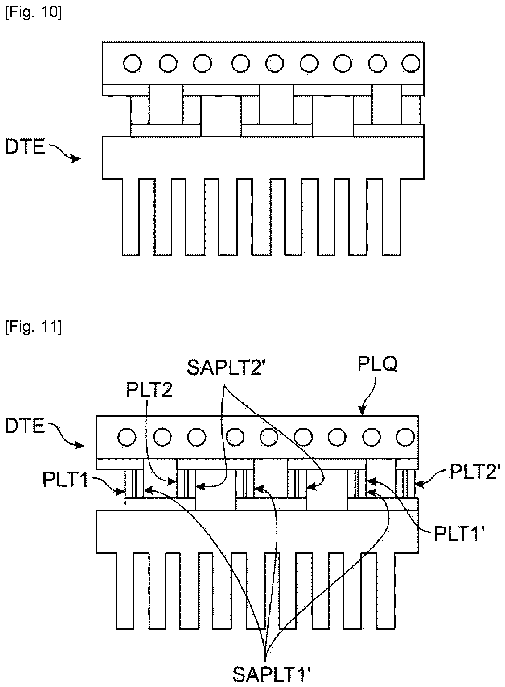

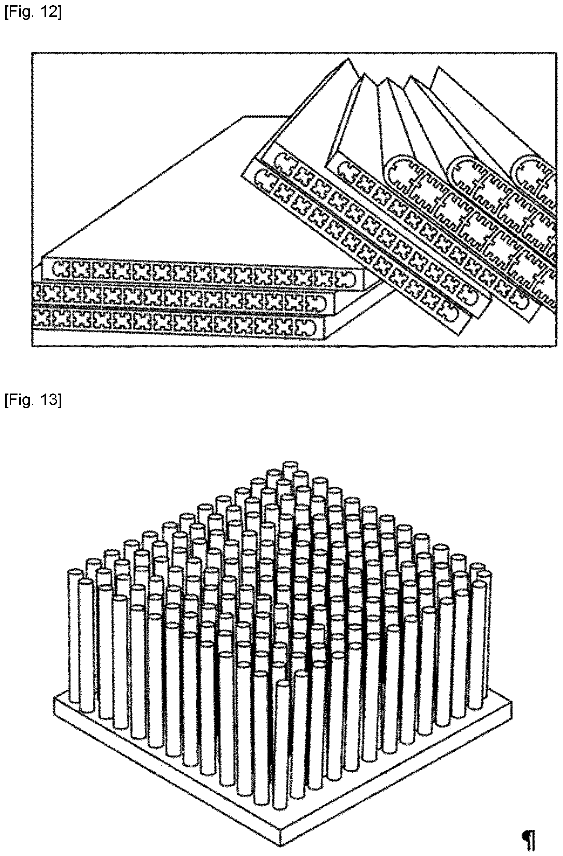

Il convient de noter que la plaque PLQ fournie à l'étape B) peut intégrer une fonction de dissipation thermique améliorée. Ainsi, la plaque PLQ peut être configurée pour former un autre dissipateur thermique. Ceci peut s'effectuer par exemple par la présence de canaux au sein de ladite plaque PLQ. C'est ce qui est représenté par exemple dans la variante de réalisation de la figure 10. D'un point de vue pratique, on a représenté sur la figure 12, , un exemple de dissipateur thermique se présentant sous la forme de plaque munies de canaux. Il est alors possible de faire circuler un fluide susceptible d'augmenter le transfert thermique. Les canaux peuvent d'ailleurs être structurés pour augmenter la surface d'échange et/ou le coefficient d'échange thermique.

Le dissipateur thermique DT fourni à l'étape A) peut faire l'objet de différentes conceptions. En effet, le dissipateur thermique peut intégrer une structure de dissipation thermique se présentant sous la forme d'ailettes agencées parallèlement, mais aussi sous la forme de plots agencés parallèlement, par exemple formés de cylindres pleins comme cela est représenté sur la figure 13 , ou à canaux comme sur la figure 12.

On a représenté sur la figure 11 un autre dispositif thermoélectrique susceptible d'être obtenu avec l'invention, dans lequel on trouve, au niveau de chaque extrémité de connexion métallique au moins deux plots semi-conducteurs agencés parallèlement.

Ceci permet d'optimiser les performances électriques de sortie du dispositif thermoélectrique DTE. Dans l'art antérieur, tous les plots semi-conducteurs sont reliés électriquement en série. Ceci peut amener à obtenir des tensions de sortie élevées (plusieurs volts), ce qui parfois est incompatible avec l'électronique associée. La possibilité de relier certains plots semi-conducteurs en parallèle permet de diminuer cette tension de sortie, tout en maintenant la puissance générée.

Pour l'obtenir, on dépose au cours de l'étape A) au moins une série de plots additionnels SAPLT1' réalisés en un matériau semi-conducteur avec le même type de dopage que les plots PLT1 semi-conducteurs de la première série de plots PSPLT1 de sorte qu'un plot additionnel PLT1' semi-conducteur est déposé au niveau de l'extrémité de chaque connexion métallique CM1 de la première série de connexions métalliques PSCM1, parallèlement au plot PLT1 semi-conducteur déjà présent de la première série de plots PSPLT1. De manière analogue, on dépose au cours de l'étape B) au moins une autre série de plots additionnels SAPLT2' réalisés en un matériau semi-conducteur avec le même type de dopage que les plots PLT2 de la deuxième série de plots PSPLT2 de sorte qu'un plot additionnel PLT2' semi-conducteur est déposé au niveau de l'extrémité de chaque connexion métallique CM2 de la deuxième série de connexions métalliques DSCM2, parallèlement au plot PLT2 semi-conducteur déjà présent de la deuxième série de plots DSPLT2.

Dans le cas d'espèce, sur la figure 11, la plaque PLQ est fonctionnalisée pour intégrer une fonction de dissipateur thermique, en l'occurrence par le biais de canaux.

Quelle que soit la variante envisagée, le matériau formant les plots semi-conducteurs peut être choisi parmi le Silicium (Si), le Silicium Germanium (SiGe), le Tellurure de Bismuth (Bi2Te3) ou dans la famille des Skuttérudites. Ces matériaux peuvent en effet se présenter sous forme d'une poudre permettant l'emploi d'une fabrication additive. Le matériau est dopé p ou n en fonction du besoin.

### Exemple de réalisation : Dispositif thermoélectrique muni d'un dissipateur thermique

On se propose de fabriquer un dispositif thermoélectrique tel que représenté sur la figure 8.

Pour l'étape A), on fournit un dissipateur thermique DT intégralement réalisé en céramique, de type à ailettes. Les connexions métalliques CM1 sont réalisés par dépôt physique en phase vapeur (PVD) sur la base BSE du dissipateur thermique DT. Chaque connexion métallique, cylindrique, est constituée comme suit : Cu (épaisseur = 200nm) + Ni (épaisseur = 5µm) + Au (épaisseur = 10nm). Les plots PLT1 semi-conducteurs sont quant à eux obtenus par fusion sur lit de poudre, la poudre étant du Silicium-Germanium (SiGe), en l'occurrence dopé n avec une puissance laser comprise entre 5W et 200W.

Pour l'étape B), on part d'une plaque PLQ, pleine, fait dans la même céramique que le dissipateur thermique fourni à l'étape A). Les connexions métalliques CM2 déposées sur la plaque PLQ sont les mêmes que celles déposées sur la base BSE du dissipateur thermique DT (mêmes dimensions, mêmes matériaux, même technique de dépôt, même motif, etc). Les plots semi-conducteurs PLT2 sont identiques aux plots obtenus à l'étape A), à la seule différence qu'ils sont dopés p ; et ils sont par ailleurs obtenus avec le même procédé dans les mêmes conditions.

Enfin, pour l'assemblage de l'étape C), on effectue un pressage à chaud. Ce pressage à chaud peut s'effectuer à une température comprise entre 100°C et 1000°C sur une durée comprise entre 1mn et 10h.

### Fin de l'exemple.

Les dispositifs thermoélectriques ainsi fabriqués peuvent concerner toutes les applications où un gradient thermique est disponible (exemple transports, industries, etc.), les applications RTG (pour « Radio-isotope Thermoelectric Generators » selon la terminologie anglo-saxonne) pour SiGe, les applications de type « Peltier » ou pour réaliser des capteurs thermiques.

## Revendications

1. Procédé de fabrication d'un dispositif thermoélectrique (DTE) muni d'un dissipateur thermique (DT) comportant les étapes suivantes :
A) réaliser (100) une première partie (PP) dudit dispositif thermoélectrique (DTE), ladite première partie (PP) étant munie d'un dissipateur thermique, selon les sous-étapes suivantes :
- fournir un dissipateur thermique (DT) muni d'une base (BSE), ladite base (BSE) étant plane et réalisée en un matériau isolant électrique,
- déposer une première série de connexions métalliques (PSCM1) sur la base (BSE) du dissipateur thermique (DT) selon un motif prédéfini, et
- déposer, par fabrication additive, une première série de plots (PSPLT1) réalisés en un matériau semi-conducteur avec un type de dopage donné de sorte qu'un plot (PLT1) semi-conducteur est déposé sur l'une et l'une seule des deux extrémités de chaque connexion métallique (CM1) de la première série de connexions métalliques (PSCM1),
B) réaliser (200) une deuxième partie (DP) du dispositif thermoélectrique (DTE) selon les sous-étapes suivantes :
- fournir une plaque (PLQ) réalisée en un matériau isolant électrique,
- déposer une deuxième série de connexions métalliques (DSCM2) sur ladite plaque (PLQ), selon un motif identique à celui de la première série de connexions métalliques (PSCM1), et
- déposer, par fabrication additive, une deuxième série de plots (DSPLT2) réalisés en un matériau semi-conducteur avec un autre type de dopage de sorte qu'un plot (PLT2) semi-conducteur est déposé sur l'une et l'une seule des deux extrémités d'une connexion métallique (CM2) de la deuxième série de connexions métalliques (DSCM2),
C) assembler (300) la deuxième partie (DP) du dispositif à la première partie (PP) du dispositif selon les sous-étapes suivantes :
- agencer une extrémité libre d'un plot (PLT1) semi-conducteur de la première partie (PP) du dispositif contre une extrémité libre de chaque connexion métallique (CM1) de la deuxième partie (DP) du dispositif, et dans le même temps, agencer une extrémité libre d'un plot (PLT2) semi-conducteur de la deuxième partie (DP) du dispositif contre une extrémité libre de chaque connexion métallique (CM1) de la première partie (PP) du dispositif, et
- réaliser un pressage à chaud.

2. Procédé selon la revendication 1, dans lequel le dissipateur thermique (DT) fourni à l'étape A) est réalisé, dans son ensemble, en un matériau isolant électrique, par exemple en céramique.

3. Procédé selon la revendication précédente, dans lequel la plaque (PLQ) fournie à l'étape B) est réalisée en un matériau identique à celui du dissipateur thermique (DT) fourni à l'étape A).

4. Procédé selon la revendication 1, dans lequel le dissipateur thermique (DT) fourni à l'étape A) comprend une structure de dissipation thermique (SDT) s'étendant à partir de sa base, ladite structure de dissipation thermique étant réalisée en un matériau choisi parmi l'acier, par exemple de l'acier 316L, de l'Aluminium (AI), du Titane (Ti), un alliage de Cuivre Zirconium (CuZr) ou du graphite.

5. Procédé selon la revendication précédente, dans lequel la base (BSE) du dissipateur thermique (DT) est réalisée en un matériau choisi parmi un mica, un polymère ou une céramique, par exemple le Marcor^{®}.

6. Procédé selon l'une des revendications précédentes, dans lequel la plaque (PLQ) fournie à l'étape B) est configurée pour former un autre dissipateur thermique, par exemple par la présence de canaux au sein de ladite plaque.

7. Procédé selon l'une des revendications précédentes, dans lequel le dissipateur thermique fourni à l'étape A) est choisi parmi un dissipateur thermique à ailettes, à plots, par exemple formés de cylindres pleins, ou à canaux.

8. Procédé selon l'une des revendications précédentes, dans lequel :
- au cours de l'étape A), on dépose au moins une série de plots additionnels (SAPLT1') réalisés en un matériau semi-conducteur avec le même type de dopage que les plots (PLT1) semi-conducteurs de la première série de plots (PSPLT1) de sorte qu'un plot additionnel (PLT1') semi-conducteur est déposé au niveau de l'extrémité de chaque connexion métallique (CM1) de la première série de connexions métalliques (PSCM1), parallèlement au plot (PLT1) semi-conducteur déjà présent de la première série de plots (PSPLT1) ;
- au cours de l'étape B), on dépose au moins une autre série de plots additionnels (SAPLT2') réalisés en un matériau semi-conducteur avec le même type de dopage que les plots (PLT2) de la deuxième série de plots (PSPLT2) de sorte qu'un plot additionnel (PLT2') semi-conducteur est déposé au niveau de l'extrémité de chaque connexion métallique (CM2) de la deuxième série de connexions métalliques (DSCM2), parallèlement au plot (PLT2) semi-conducteur déjà présent de la deuxième série de plots (DSPLT2).

9. Procédé selon l'une des revendications précédentes, dans lequel le matériau formant les plots (PLT1, PLT1', PLT2, PLT2' ) semi-conducteurs est choisi parmi le Silicium (Si), le Silicium Germanium (SiGe), le Tellurure de Bismuth (Bi2Te3), ou dans la famille des Skuttérudites.

10. Procédé selon l'une des revendications précédentes, dans lequel ladite technique de fabrication additive est choisie parmi :
- la fusion laser sur lit de poudre, par exemple la fusion sélective par laser (SLM) ou le frittage sélectif par laser (SLS), ou
- le dépôt d'énergie direct (DED).
